Europäisches Patentamt

European Patent Office

Office européen des brevets

(11) Numéro de publication: **0 192 122**
**A1**

## DEMANDE DE BREVET EUROPEEN

(21) Numéro de dépôt: 86101477.7

(22) Date de dépôt: 05.02.86

(51) Int. Cl.⁴: **H03G 3/32** , H03G 5/04

(30) Priorité: 11.02.85 FR 8501904

(43) Date de publication de la demande:
27.08.86 Bulletin 86/35

(84) Etats contractants désignés:
AT BE CH DE GB IT LI NL SE

(71) Demandeur: **Carpentier, Claude**
**163, rue Armand Silvestre**
**F-92400 Courbevoie(FR)**

(72) Inventeur: **Carpentier, Claude**
**163, rue Armand Silvestre**
**F-92400 Courbevoie(FR)**

(74) Mandataire: **Casalonga, Axel et al**
**BUREAU D.A. CASALONGA OFFICE JOSSE &**
**PETIT Morassistrasse 8**
**D-8000 München 5(DE)**

(54) Amplificateur audio pour automobile.

(57) Amplificateur à basse fréquence, principalement pour automobile, du type comportant un dispositif d'égalisation et un dispositif de compensation du bruit ambiant, caractérisé par le fait que le dispositif d'égalisation (1a) est un dispositif du type à corrections fixes placé en aval de l'amplificateur à gain commandé (2) chargé de la compensation du bruit ambiant.

## FIG.2

EP 0 192 122 A1

Amplificateur audio pour automobile.

L'invention concerne la reproduction sonore à bord d'une automobile.

Cette reproduction sonore à bord d'une automobile pose un certain nombre de problèmes spécifiques. Ceux de ces problèmes qui sont du ressort de l'électro-acoustique peuvent se classer en deux catégories : d'une part, ceux ayant trait au bruit ambiant, et d'autre part, ceux ayant trait à l'équilibre sonore. Dans tous les dispositifs de reproduction sonore connus, ces deux problèmes sont traités indépendamment l'un de l'autre.

L'état de la technique en ce qui concerne la compensation du volume sonore en fonction du bruit ambiant peut être illustré par les brevets français n° 2 435 879, 2 466 901, 2 513 839 et 2 529 727.

L'état de la technique en ce qui concerne l'équilibre sonore est beaucoup moins abondant et peut être illustré par le brevet français 2 514 213 au nom du demandeur.

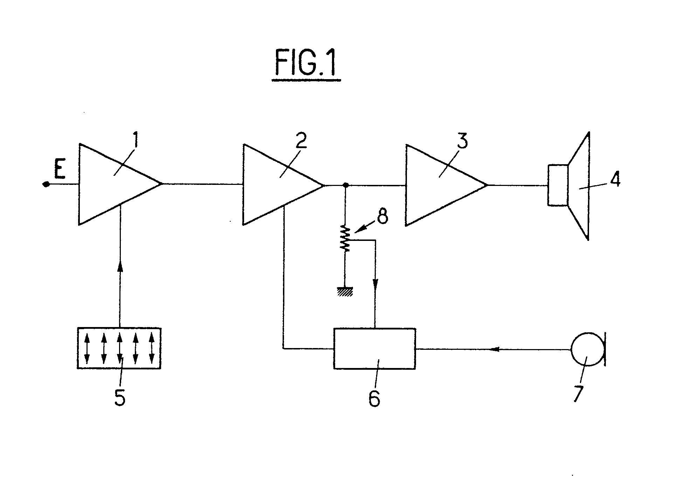

La figure 1 montre le schéma de base d'un appareil commercialisé sous l'appellation de "S-TRONIC MK3" et qui représente l'état de la technique la plus sophistiquée en matière d'amplificateur pour automobile.

A partir de l'entrée de signaux E, on trouve tout d'abord un égaliseur 1, suivi d'un amplificateur à gain commandé 2, lui-même suivi d'un amplificateur de puissance 3 qui alimente un haut-parleur 4. L'égaliseur 1 comporte un dispositif de commande 5 incluant un certain nombre de potentiomètres de réglage. De son côté, l'amplificateur à gain commandé 2 est piloté par un circuit 6 qui élabore une tension de commande à partir des niveaux respectifs des signaux en provenance, d'une part d'un microphone d'ambiance 7, et d'autre part de la modulation prise en aval de l'amplificateur à gain commandé 2 à travers un potentiomètre de réglage 8.

Les différents dispositifs de commande automatique de volume diffèrent essentiellement par la constitution du circuit 6 qui peut être plus ou moins complexe afin de tenir compte de divers paramètres.

Mais quelle que soit la constitution du circuit 6, il est une fonction de base qui doit toujours être assurée et qui est l'estimation du niveau du bruit ambiant. Cette estimation s'effectue par comparaison des niveaux respectifs des signaux issus du microphone 7, et composés de bruit produit par la voiture et de signal produit par le haut-parleur, et du prélèvement 8 ne contenant que du signal. Cette estimation est faite avec une erreur dB donnée par la formule :

$$dB = dS \times S/B$$

dans laquelle dS est l'erreur de non linéarité de la chaîne électroacoustique haut-parleur-local-micro, et S/B est le rapport entre le signal utile et le bruit ambiant.

Le but de l'invenvion est de réaliser un amplificateur audio pour automobile qui élimine les inconvénients précédents en assurant à la fois la commande automatique de volume et l'équilibre sonore d'une manière efficace et sans réglages multiples et délicats.

L'idée de base de la présente invention est la suivante : si l'on place un microphone suffisamment linéaire à proximité de la tête de l'auditeur, la courbe d'égalisation nécessaire à assurer à l'écoute un bon équilibre sonore est la même que celle nécessaire à assurer une faible erreur dS. Or, d'une part, il existe des microphones à électret très bons marchés et très linéaires, et d'autre part, la proximité de l'auditeur est une place de choix pour un microphone chargé de capter le bruit ambiant.

L'invention consiste à utiliser un égaliseur à correction fixe et à le placer en aval de l'amplificateur à gain commandé et du point de prise du signal. Elle consiste aussi à utiliser un microphone dont la courbe de réponse est connue et à le placer de préférence à proximité de la tête de l'auditeur, bien que d'autres endroits puissent convenir comme par exemple la face avant des autoradios.

En effet, dans ce cas, l'expérience montre que l'on obtient toujours pour le réglage de l'égaliseur un compromis très acceptable entre la qualité sonore et la compensation du bruit ambiant. Ce résultat, quelque peu surprenant, provient du fait que la pression acoustique est uniformément répartie dans l'habitacle à la fréquence de résonance principale de la voiture qui est la plus gênante pour la stabilité et l'équilibre sonore. D'autre part, les irrégularités provenant des haut-parleurs eux-mêmes se retrouvent aussi dans tout l'habitacle.

Cette possibilité d'obtenir des résultats tout à fait satisfaisants en plaçant le micro sur la face avant de l'autoradio est particulièrement intéressant par la simplification qu'elle apporte. Le seul inconvénient de cette configuration est l'éloignement du microphone de la fenêtre du conducteur, d'où une perte dans le rapport signal utile/bruit ambiant lorsque la fenêtre est ouverte, car la tête du conducteur est alors plus exposée au bruit que le micro.

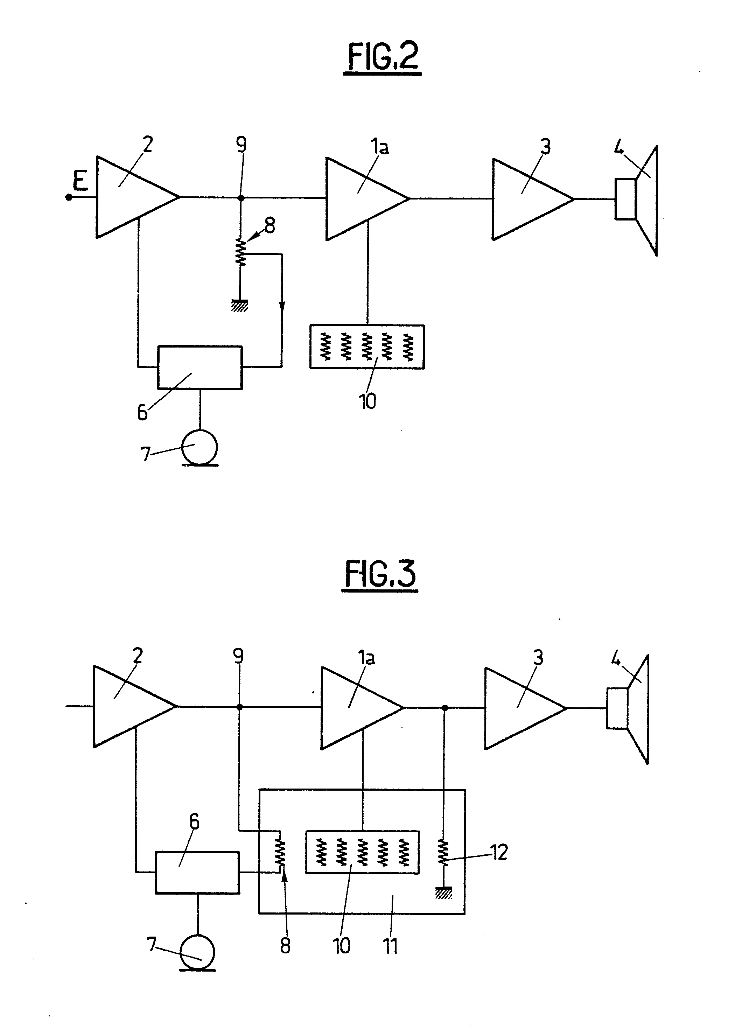

D'autres particularités de l'invention apparaîtront dans la description qui va suivre d'un mode de réalisation pris comme exemple et représenté sur la figure 2, par comparaison avec l'état de la technique représenté par la figure 1.

Comme exposé précédemment, selon l'état de la technique représenté par la figure 1, l'égaliseur 1 est obligatoirement placé en amont de l'amplificateur à gain commandé 2, car s'il était placé en aval, toute manipulation de la part de l'utilisateur sur les potentiomètres de réglage du dispositif de commande 5 de l'égaliseur détruirait le réglage du potentiomètre 8 de prélèvement du signal et provoquerait l'instabilité du dispositif de compensation du bruit ambiant.

Au contraire, selon l'invention, et comme il ressort de la figure 2, on utilise un égaliseur 1a du type à correction fixe, par exemple du type décrit dans le brevet français 2 514 213 au nom du demandeur, et on le place en aval de l'amplificateur à gain commandé 2 et du point 9 de prélèvement du signal.

Si l'égaliseur 1a fournit la courbe inverse de la courbe obtenue sans égaliseur au niveau du micro 7, l'erreur dS sera nulle et l'équilibre sonore parfaitement réglé.

A titre de perfectionnement, afin que l'amplificateur suivant l'invention soit apte à s'adapter à des configurations multiples, les moyens 10 de réglage de l'égaliseur et 8 de réglage du dispositif de compensation du bruit ambiant sont réunis sur une plaquette escamotable 11, comme l'illustre la figure 3.

Par ailleurs, l'expérimentation du dispositif selon l'invention a montré qu'un réglage actuellement confié à l'utilisateur devait lui être retiré : c'est le réglage du rapport de volume entre les haut-parleurs avant et arrière, plus communément appelé FADER dans le cas des amplificateurs à quatre canaux. En effet, les mesures montrent que le changement de réglage du rapport avant/arrière a une influence considérable sur la réponse en fréquences basses. Il est donc avantageux d'en prérégler également les niveaux optimum, ce qui peut être obtenu également à l'aide de résistances fixes supplémentaires 12 sur la plaquette indiquée précédemment.

**Revendications**

1. Amplificateur à basse fréquence, principalement pour automobile, du type comportant un dispositif d'égalisation et un dispositif de compensation du bruit ambiant, caractérisé par le fait que le dispositif d'égalisation (1a) est un dispositif du type à corrections fixes placé en aval de l'amplificateur à gain commandé (2) chargé de la compensation du bruit ambiant.

2. Amplificateur selon la revendication 1, caractérisé par le fait que les moyens de réglage (10) de l'égaliseur et (8) du dispositif de compensation du bruit ambiant sont réunis sur un support amovible et interchangeable de manière à s'adapter à des configurations particulières prédéterminées à l'avance.

3. Amplificateur selon la revendication 2, comportant plusieurs canaux, caractérisé par le fait que le niveau relatif des canaux est préréglé par un moyen de réglage situé sur ledit support amovible.

# FIG.1

0 192 122

## FIG.2

## FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.⁴) |
|---|---|---|---|
| Y | FR-A- 898 796 (ALBISWERK ZÜRICH) * Figures 2,3; page 6, ligne 70 - page 7, ligne 47 * | 1 | H 03 G 3/32 H 03 G 5/04 |
| Y,D | FR-A-2 514 213 (CARPENTIER) | 1 | |

DOMAINES TECHNIQUES RECHERCHES (Int. Cl.⁴)

H 03 G

Le présent rapport de recherche a été établi pour toutes les revendications

| Lieu de la recherche | Date d'achèvement de la recherche | Examinateur |
|---|---|---|
| LA HAYE | 29-04-1986 | GYSEN L.A.D. |